# FASCICULE DE BREVET EUROPEEN

(11) **EP 3 714 403 B1**
(45) Date de publication et mention de la délivrance du brevet: **16.06.2021**
(21) Numéro de dépôt: 18819312.2
(22) Date de dépôt: 20.11.2018
(51) Int. Cl.: G06K 19/077

(54) **MODULE ÉLECTRONIQUE À ANTENNE OPTIMISÉE POUR CARTE À PUCE À DOUBLE INTERFACE DE COMMUNICATION**
FÜR EINE CHIPKARTE MIT DOPPELTER KOMMUNIKATIONSSCHNITTSTELLE OPTIMIERTES ELEKTRONISCHES ANTENNENMODUL
ELECTRONIC ANTENNA MODULE OPTIMISED FOR A CHIP CARD WITH A DUAL COMMUNICATION INTERFACE

(30) Priorité: 24.11.2017 FR 1701231
(43) Date de publication de la demande: 30.09.2020
(73) Titulaire: Smart Packing Solutions, 13790 Rousset (FR)
(72) Inventeur: CALVAS, Bernard, 13790 Rousset (FR); GERIN, Guillaume, 13106 Rousset Cedex (FR); FABRIZIO, Kevin, 13106 Rousset Cedex (FR)
(74) Mandataire: Nicolle, Olivier
(86) Numéro de dépôt international: PCT/FR2018/000252
(87) Numéro de publication internationale: WO 2019/102079

(56) Documents cités:
- FR-A1- 2 996 944
- FR-A1- 2 998 395
- US-A1- 2015 278 675

## Description

L'invention concerne un module électronique à double interface de communication à contact et sans contact, et une carte à puce intégrant un tel module.

### Etat de la technique

Il existe déjà dans l'état de la technique des cartes à puce à fonctionnement mixte à contact et sans contact. La plupart présente un module microélectronique pourvu d'une part de contacts normalisés selon la norme ISO 7816-2 correspondants aux contacts d'un lecteur de cartes à puce, et d'autre part d'une interface de communication radiofréquence pourvue d'au moins une antenne et apte à communiquer avec l'antenne d'un lecteur sans contact.

Lorsque la carte à puce comporte une antenne réalisée dans le corps de carte, elle est quelquefois connectée directement à l'interface sans contact du module microélectronique, et cette connexion mécanique entre l'antenne et le module induit alors des pertes de fiabilité ou de rendement de fabrication. En effet, les sollicitations mécaniques et thermiques imposées à la carte lors de son utilisation peuvent entraîner des ruptures de la connexion entre le module et l'antenne, ou des augmentations fortes de la résistance électrique de cette connexion, entraînant une perte de performance de la carte au cours de son utilisation.

C'est pourquoi on a utilisé de plus en plus souvent des modules pour cartes à puce à double interface de communication, comportant une petite antenne située directement sur le module, et une seconde antenne de plus grande taille située dans le corps de carte, encore appelée antenne "booster", couplée avec l'antenne du module mais non physiquement connectée à elle.

Dans ce cas, pour fabriquer une carte à puce, il suffit de simplement reporter le module à double interface de communication dans un corps de carte à puce, ce qui est aisé à réaliser avec un faible coût et une grande fiabilité avec la plupart des machines d'encartage classiques utilisées pour la fabrication des cartes à puce à contact.

Mais de nouveaux problèmes sont apparus. Ainsi, les modules à double interface de communication possédant des contacts métalliques sur leur face supérieure, et une puce microélectronique ainsi que les pistes de l'antenne du module situées sur leur face inférieure, la connexion électrique des bornes de la puce avec les contacts et l'antenne a nécessité la réalisation de vias métallisés réalisant une connexion électrique entre les faces du module, avec pour effet des coûts de production relativement élevés.

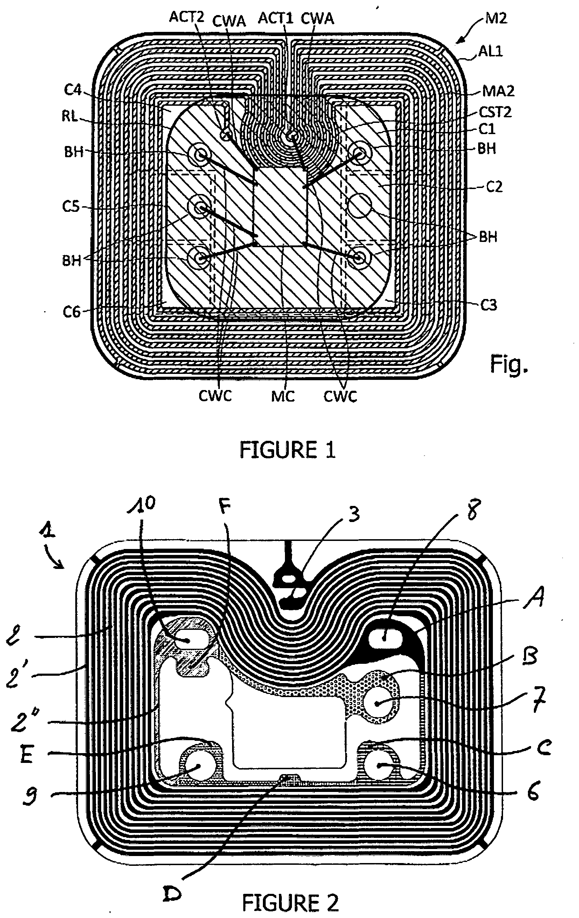

Pour remédier à ce problème, il a été prévu, comme par exemple dans les documents FR 12 01866 A1 et FR 2 996 944, de déplacer les deux extrémités de l'antenne du module à l'intérieur de la zone d'encapsulation de la puce, comme représenté dans la Figure 1 de la présente demande, qui reprend la figure 7 du document FR 12 01866 A1 précité. De cette manière, les bornes de la puce pouvaient être connectées à la fois aux contacts ISO et aux bornes de l'antenne du module, à l'intérieur de la goutte d'encapsulation de la puce, sans que des vias ne soient nécessaires. Par contre, pour éviter des croisements de fils et donc des court-circuit, il a fallu détourner la nappe de spires de l'antenne du module pour l'amener en partie dans la zone d'encapsulation, sous la forme d'un décrochement de la nappe de spires contournant l'extrémité distale de l'antenne (à savoir l'extrémité de la spire externe de l'antenne du module), comme cela est visible dans la Figure 1.

Cette disposition était acceptable pour des modules de grande taille, de type dit "DUAL8" ayant une taille de 11.8 x 13 mm², offrant suffisamment de place pour le décrochement des spires de l'antenne.

Entretemps, la demande du marché a encore évolué, en particulier dans le domaine des cartes à puce pour les applications bancaires, exigeant l'usage de modules à double interface de communication de plus petite taille, de type dit "DUAL 6", ayant une taille réduite à 8.3 x 11 mm²). Or réduire la taille des modules implique en particulier de réduire la taille des spires de leur antenne, et donc, pour un même nombre de spires, à réduire l'impédance L de l'antenne, ce qui entraine la diminution du produit L.C (C représentant la capacité de la puce microélectronique), et l'augmentation de la fréquence de résonance f du module, égale à 1/(2Π√L.C). Cela rend les cartes à puce utilisant un tel module impropre à communiquer avec les lecteurs sans contact existants sur leur fréquence de fonctionnement nominale.

Pour réduire la taille du module tout en conservant la fréquence de résonance normale, il est donc nécessaire d'augmenter la valeur de l'impédance L de l'antenne du module, étant donné qu'il n'est pas envisageable d'intervenir sur la capacité C des puces fournies par les fabricants de puces.

Afin d'augmenter de façon sensible la valeur de l'inductance L de l'antenne du module, tout en conservant ses principaux paramètres de conception (largeur des pistes d'antenne, distance inter pistes), il est nécessaire d'allonger la longueur utile de l'antenne, en augmentant le nombre de spires.

Or augmenter le nombre de spires de l'antenne du module, dans un espace plus restreint du fait de la diminution de la taille du module, est une tâche paradoxale, et nécessite de procéder à certains changements dans la conception du module, sans renoncer aux avantages déjà obtenus liés à l'absence de vias.

### Buts de l'invention

Un but général de l'invention est par conséquent de proposer un module électronique à double interface de communication à contact et sans contact, qui soit dépourvu des inconvénients précités liés à la réduction de la taille des modules.

Un but particulier de l'invention est de proposer un module électronique pour carte à puce à double interface de communication à contact et sans contact, présentant des valeurs d'inductance plus élevées que dans l'état de la technique, pour compenser la diminution de la taille des modules, en particulier les modules à six contacts de dimensions 8.3 x 11 mm² utilisés dans les applications bancaires.

Un autre but particulier de l'invention est de proposer un module électronique à double interface de communication à contact et sans contact qui permette de présenter plusieurs valeurs d'inductance de l'antenne du module, pour s'adapter à différentes capacités des puces microélectroniques disponibles sur le marché, tout en conservant les avantages liés à une antenne de module pourvue d'un décrochement amenant les spires de l'antenne à contourner l'extrémité distale de l'antenne.

### Résumé de l'invention

Dans son principe, l'invention prévoit d'augmenter la place disponible pour le décrochement des spires de l'antenne, qui doit passer dans un triangle situé entre les deux puits de connexion des deux contacts normalisés C1, C5 du module, et la borne distale de l'antenne du module.

Par conséquent, l'invention prévoit d'augmenter la taille de ce triangle, d'une part en reportant la borne de connexion de l'extrémité distale de l'antenne en limite de la zone d'encapsulation du module, et d'autre part en écartant autant que possible les bords internes des puits de connexion des contacts du module qui sont les plus proches de l'extrémité distale de l'antenne, par exemple les contacts normalisés C1 et C5, ou C3 et C7, ou C5 et C7, en fonction du positionnement du décrochement de l'antenne.

En outre, on pourra réduire la hauteur de ces puits de connexion dans le sens du décrochement et leur donner une forme oblongue.

Grâce à ces mesures, il sera possible d'ajouter plusieurs spires à l'antenne, et donc d'augmenter la valeur de l'inductance L de l'antenne du module, tout en conservant sensiblement la taille des pistes et les distances inter pistes.

Par ailleurs, l'invention prévoit que la piste interne de l'antenne du module soit pourvue de plusieurs plots de connexion proximaux, constituant autant d'options possibles de connexion à l'interface sans contact de la puce microélectronique. Grâce à cette mesure, il sera possible d'adapter plus finement l'impédance L de l'antenne du module à la capacité C effective de la puce qui sera utilisée pour la fabrication du module.

L'invention a par conséquent pour objet un module électronique pour carte à puce, comportant un substrat présentant sur une première face un bornier de contacts électriques (C1,C2,C3,C5,C6,C7) normalisés selon la norme ISO 7816 permettant un fonctionnement par contact avec les contacts correspondants d'un lecteur de carte à puce, et comportant sur une seconde face une antenne et une puce microélectronique protégée par une zone d'encapsulation et la puce étant pourvue d'une interface de communication à contact et d'une interface de communication sans contact, les contacts électriques (C1-C7) étant connectés à la puce par des fils conducteurs passant dans des puits de connexion, l'antenne comportant une pluralité de spires situées en périphérie du module et un plot de connexion proximal et un plot de connexion distal disposés à l'intérieur de la zone d'encapsulation et destinés à être connectés à des bornes correspondantes de ladite interface de communication sans contact de la puce, et les spires de l'antenne comportant un décrochement localisé contournant le plot de connexion distal et orienté en direction de la puce, le plot de connexion distal étant situé à une faible distance d du bord de la zone d'encapsulation, caractérisé en ce que les bords internes des puits de connexion des deux contacts les plus proches du plot de connexion distal sont écartés vers l'extérieur du module par rapport aux bords internes des puits de connexion des autres contacts, de manière à maximiser l'espace disponible entre le plot de connexion distal et lesdits puits de connexion pour le passage des pistes de l'antenne.

De cette manière, le triangle formé par le plot de connexion distal et les puits de connexion les plus proches du plot de connexion distal est de taille maximale et permet le passage d'un plus grand nombre de spires d'antenne, et conduit donc à une augmentation de l'inductance L de l'antenne.

Selon une variante de réalisation avantageuse du module, la distance d entre le bord de la zone d'encapsulation et le bord externe du plot de connexion distal est comprise entre 0 et 500 micromètres.

Selon un mode de réalisation avantageux en particulier pour le modules de petite taille (8, 3 x 11 mm²), la distance d'écartement E1 entre les bords internes des puits de connexion les plus proches du plot de connexion distal a une valeur d'environ 6 millimètres.

Selon un mode de réalisation avantageux en particulier pour le modules de petite taille (8, 3 x 11 mm²), la distance d'écartement E2 entre les bords externes des puits de connexion les plus proches du plot de connexion distal a une valeur d'environ 7 millimètres.

Selon un mode de réalisation préféré, les puits de connexion des contacts situés au voisinage du décrochement de l'antenne sont de forme oblongue pour faciliter le passage des fils de connexion entre la puce et lesdits contacts. La largeur de ces puits de connexion est alors inférieure à 600 micromètres.

Selon un mode de réalisation avantageux, la spire la plus interne de l'antenne entoure la zone de la puce microélectronique et comporte plusieurs plots proximaux (A,B,C,D,E,F) répartis le long de la spire interne et correspondant à des longueurs d'antenne différentes et à des inductances différentes, de sorte que l'antenne située entre le plot distal et l'un des plots proximaux (A,B,C,D,E,F) possède une inductance L apte à être sélectionnée, lors de sa connexion à la puce microélectronique et en fonction de la capacité C de celle-ci, pour obtenir une fréquence de résonnance cible.

Selon un mode de réalisation, la spire interne de l'antenne du module comporte au moins six plots de connexion proximaux.

Grâce à l'invention, l'inductance L de l'antenne est comprise, en fonction du plot proximal connecté, entre 1,3 et 1,45 micro Henry et permet de connecter une puce dont la capacité C est comprise entre 45 et 104 pico Farad, tout en obtenant la fréquence de résonance recherchée.

L'invention a également pour objet une carte à puce à double interface de communication à contact et sans contact, caractérisée en ce qu'elle comporte un module électronique présentant les caractéristiques ci-dessus.

D'autres caractéristiques et avantages de l'invention apparaîtront à la lecture de la description détaillée et des dessins annexés dans lesquels :
- la Figure 1 est vue en plan d'un module électronique à double interface de communication conforme à l'état de la technique ;
- la Figure 2 est une vue en plan de l'antenne pour réaliser un module électronique conforme à l'invention;
- les Figures 3A et 3B à 3D sont respectivement une vue en plan de la face arrière (côté antenne) et des vues en coupe d'un module électronique selon l'invention, utilisant l'antenne de la Figure 2;
- la Figure 4 est une vue en plan de l'antenne similaire à la Figure 3, montrant des détails de réalisation;
- la Figure 5 est une vue en plan de la face avant (face à contacts) du module selon l'invention;
- les Figures 6A à 6E sont des vues en plan de la face arrière du module électronique selon l'invention, dans différentes configurations de câblage.

### Description détaillée

La Figure 1 correspond à la figure 7 du document FR 12 01866 A1 décrivant un module électronique pour carte à puce conforme à l'état de la technique. Le module M2 comporte un ensemble de 8 spires MA2, s'étendant entre l'extrémité distale, qui est l'extrémité de la spire externe, notée ACT1, et l'extrémité proximale, qui est l'extrémité de la spire interne, notée ACT2. Les spires présentent un décrochement en direction de la puce microélectronique notée MC, et passant dans le triangle formé par l'extrémité distale ACT1 et les puits de connexion des contacts métalliques référencés C1 et C4. Les extrémités distale ACT1 et proximale ACT2 de l'antenne se trouvent nettement à l'intérieur de la zone d'encapsulation notée RL, qui correspond à une goutte de résine protégeant la puce et ses plots de connexion. Les puits d'accès BH aux contacts sont alignés en deux rangées verticales de part et d'autre de la puce, de ce fait le triangle formé par ACT1 et les deux puits BH supérieurs qui sont les plus proches de ACT1 est de taille réduite, ce qui réduit la largeur disponible pour la nappe de spires et convient mieux aux modules de grande taille. Il en résulte une limite sur la longueur de l'antenne et donc sur son inductance. Par ailleurs, l'inductance de l'antenne de la Figure 1 est toujours fixe et ne permet pas de s'adapter à la capacité de puces différentes.

La Figure 2 représente la face arrière (côté antenne) d'un module 1 pour carte à puce conforme à l'invention. Par mesure de clarté, on n'a représenté ici que les métallisations correspondant à l'antenne 2, sans représenter ni la puce ni les contacts métalliques du bornier. Bien que l'invention ne soit pas limitée aux modules de petite taille (DUAL6), on a représenté ici un module de petite taille, à savoir une taille de 8,3 x 11 mm² correspondant à un standard d'usage. Malgré sa petite taille, l'antenne 2 comporte 13 spires, au lieu de 8 spires dans la Figure 1. Cela permet de compenser au moins en partie la réduction de l'inductance L de l'antenne, due à la diminution de la taille du module.

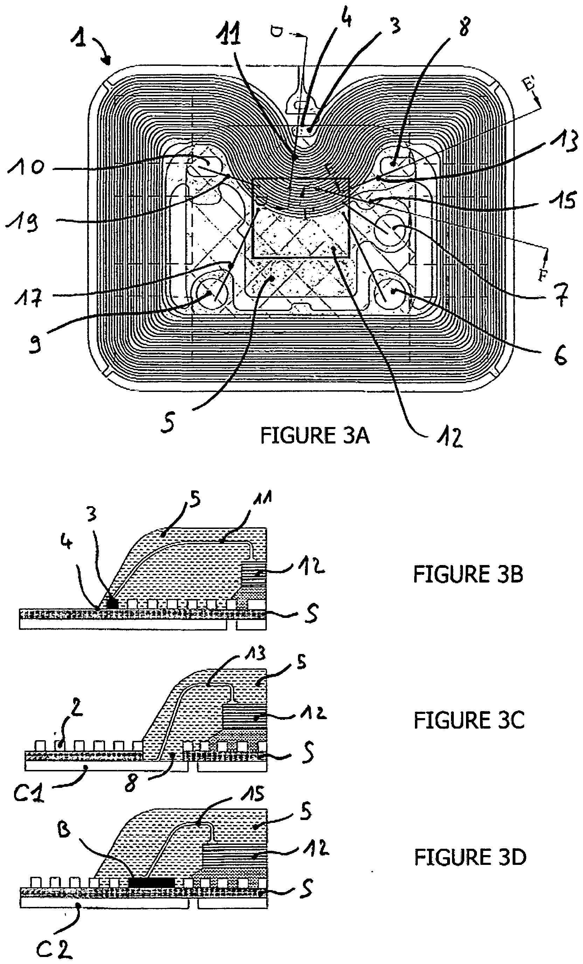

Afin d'obtenir ce résultat, l'extrémité distale 3 de l'antenne a été reportée à la limite de la zone d'encapsulation 5 (Figure 3A).

Plus précisément, la limite externe de l'extrémité distale 3 de l'antenne 2 est comprise à une distance d de la limite 4 de la goutte d'encapsulation 5 comprise entre 0 et 500 micromètres.

En outre, dans l'exemple représenté, les puits de connexion 6, 7, 8 de la puce aux contacts C1,C2,C3 et les puits de connexion 9,10 de la puce aux contacts C5, C7 ne sont plus alignés selon deux axes verticaux, mais les puits de connexion 8, 10 correspondant aux contacts C1 et C5 ont été écartés et déportés en direction des bords externes du module, par rapport aux puits de connexion 6, 7, 9 des contacts normalisés C2, C3, C7.

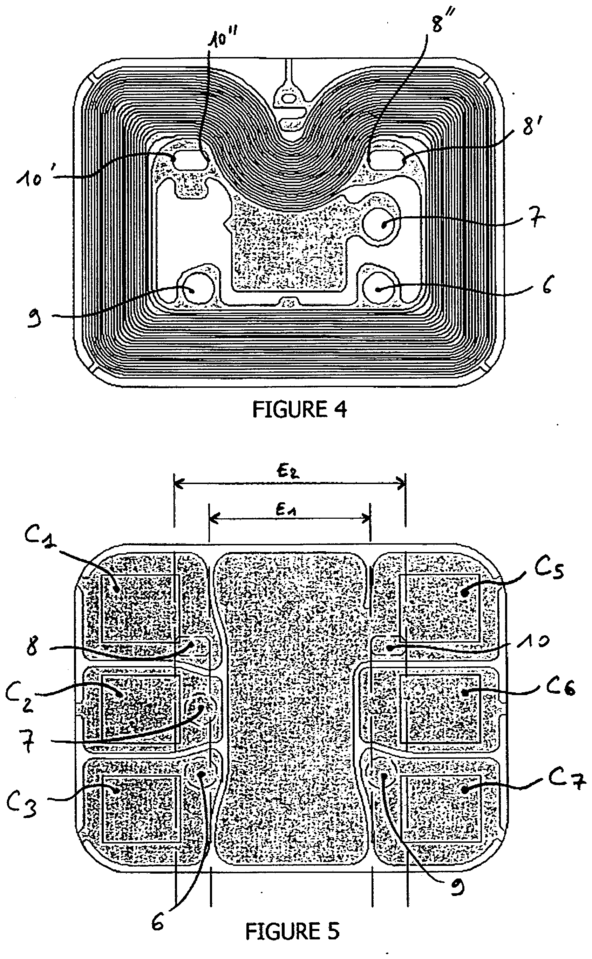

Plus précisément, comme représenté en Figure 4, les bords internes 8" et 10" des puits de connexion 8,10 qui sont les plus proches de l'extrémité distale 3 de l'antenne, ont été légèrement décalés vers l'extérieur, de sorte que, comme représenté en Figure 5, la valeur de la distance E1 entre les bords internes 8", 10" passe de 4 mm dans les modules connus, à environ 6 mm dans le module selon l'invention. De ce fait il devient possible d'élargir la nappe de spires de l'antenne 2.

En outre, les points de connexion des fils 13, 19 dans les puits de connexion 8, 10, (Figure 3A) sont également écartés, d'une valeur de 400 à 500 micromètres de chaque côté, pour faciliter la connexion de ces fils sans les mettre en court-circuit avec le métal de l'antenne 2. Ceci impose que les bords externes 8' et 10' des puits de connexion 8,10 soient eux aussi écartés pour atteindre une distance E2 (Figure 5) d'environ 7 mm, au lieu de 5 mm pour les modules connus. Le déplacement vers l'extérieur des puits de connexion des contacts C1, C5 rend plus difficile l'atterrissage des fils de connexion 13, 19 venant de la puce 12 et allant vers lesdits puits. Afin de compenser cette difficulté, l'invention prévoit de donner aux puits de connexion 8, 10 des contacts C1, C5 une forme oblongue avec un aplatissement selon l'axe du décrochement 20 de l'antenne 2, afin que les fils de connexion puissent être connectés sans toucher la métallisation de la spire interne 2' de l'antenne. La largeur des puits de connexion 8, 10 est alors de préférence inférieure à 600 micromètres.

Il est à noter que dans l'exemple représenté, l'extrémité distale 3 de l'antenne 2 se trouve à proximité des contacts normalisés C1, C5, mais les principes de l'invention pourraient aisément être transposés à d'autres cas de figure, par exemple avec l'extrémité distale positionnée entre les contacts C5 et C7, ou entre les contacts C3 et C7.

Afin d'adapter au mieux la valeur de l'impédance L de l'antenne du module à la capacité C de la puce pour obtenir une fréquence de résonance cible, un mode de réalisation préféré de l'invention prévoit que la spire interne 2" de l'antenne comporte une pluralité de plages de connexion proximales, comme représenté en Figure 2. Dans cette figure, on a prévu 6 plages de connexion A,B,C,D,E et F, réparties le long de la spire interne 2" et correspondant à des valeurs croissantes de l'impédance de l'antenne. Ainsi on pourra choisir la plage de connexion la plus appropriée en fonction de la capacité de la puce qui sera effectivement utilisée dans un module donné.

La Figure 3A représente un module électronique selon l'invention, vu du côté inférieur c'est-à-dire du côté faisant apparaître l'antenne 2, la puce 12, et les fils 11, 13, 15, 17, 19 pour la connexion entre la puce et l'antenne ou les contacts à travers les puits de connexion (ou puits de « bonding » en terminologie anglo-saxonne). La partie des zones métalliques correspondant aux contacts Cl-C7 réglementée par la norme ISO 7816-2 et 7816-3 est représentée en trait interrompu. La goutte d'encapsulation 5 de la puce est représentée en motif hachuré. Comme on le voit, l'extrémité distale 3 de l'antenne 2 est positionnée dans la zone d'encapsulation 5, en limite 4 de celle-ci.

La Figure 3B correspond à une vue partielle en coupe du module 1 selon le plan de coupe D-D, montrant le fil de connexion 11 entre la puce 12 et l'extrémité distale 3 de l'antenne, positionnée à la périphérie 4 de la goutte d'encapsulation 5.

La Figure 3C correspond à une vue partielle en coupe du module 1 selon le plan de coupe E-E, montrant le fil de connexion 13 entre la puce 2 et le contact C1 du module.

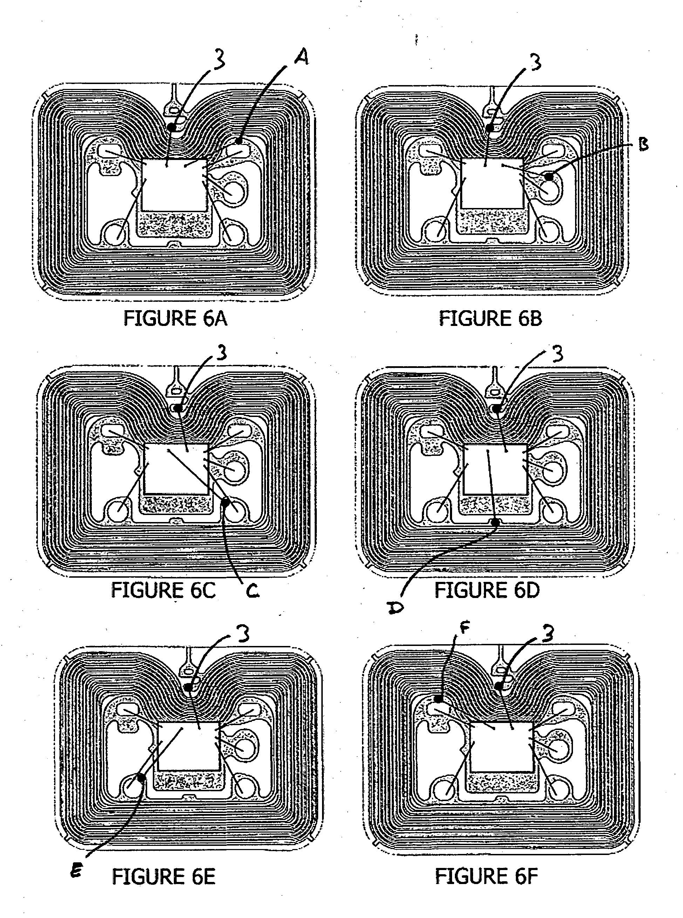

La Figure 3D correspond à une vue partielle en coupe du module 1 selon le plan de coupe F-F, montrant le fil de connexion 15 entre la puce 2 et l'une des connexions proximales B de l'antenne. Les différentes options de connexion de l'antenne 2 ont été schématisées en Figure 6. Dans tous les cas une borne de l'interface de communication sans contact de la puce 2 est connectée à l'extrémité distale 3 de l'antenne, et son autre borne est connectée à l'une des plages proximales A (figure 6A), B (figure 6B), C (figure 6C), D (figure 6D), E (figure 6E) ou F (figure 6F) disponibles sur l'antenne, correspondant à des valeurs croissantes de l'inductance L de l'antenne 2.

On a pu constater en pratique que cette disposition permettait d'utiliser la même antenne, avec des puces ayant des capacités C variant entre des valeurs comprises entre environ 45 pF et environ 104 pF, correspondant à l'essentiel des puces pour cartes à puce couramment disponibles

### Avantages de l'invention

En définitive, l'invention atteint les buts fixés. Elle propose une conception de de module électronique pour carte à puce à double interface de communication permettant d'intégrer une antenne de plus grande taille sur un module de taille réduite.

En outre, grâce aux différentes options de connexion de l'antenne, elle permet d'optimiser la fréquence de résonance des modules en fonction des différentes valeurs de capacités des puces microélectroniques du marché, variables typiquement entre 45 et 104 pF.

Ces avantages sont obtenus sans remettre en cause des avancées précédentes, comme l'intégration des extrémités de l'antenne du module à l'intérieur de la zone d'encapsulation de la puce.

## Revendications

1. Module électronique (1) pour carte à puce, comportant un substrat (S) présentant sur une première face un bomier de contacts électriques (C1,C2,C3,C5,C6,C7) normalisés selon la norme ISO 7816 permettant un fonctionnement par contact avec les contacts correspondants d'un lecteur de carte à puce, et comportant sur une seconde face une antenne (2) et une puce microélectronique (12) protégée par une zone d'encapsulation (5) et la puce étant pourvue d'une interface de communication à contact et d'une interface de communication sans contact, les contacts électriques (C1-C7) étant connectés à la puce (12) par des fils conducteurs (13, 17, 19) passant dans des puits de connexion (8,7,6), l'antenne (2) comportant une pluralité de spires situées en périphérie du module et un plot de connexion proximal et un plot de connexion distal (3) disposés à l'intérieur de la zone d'encapsulation (5) et destinés à être connectés à des bornes correspondantes de ladite interface de communication sans contact de la puce (12), et les spires de l'antenne (2) comportant un décrochement localisé (20) contournant le plot de connexion distal (3) et orienté en direction de la puce (12), le plot de connexion distal (3) étant situé à une faible distance d du bord (4) de la zone d'encapsulation (5), **caractérisé en ce que** les bords internes (8",10") des puits de connexion (8,10) des deux contacts les plus proches du plot de connexion distal (3) sont écartés vers l'extérieur du module par rapport aux bords internes des puits de connexion des autres contacts, de manière à maximiser l'espace disponible entre le plot de connexion distal (3) et lesdits puits de connexion (8,10) pour le passage des pistes de l'antenne.

2. Module électronique (1) selon la revendication 1, **caractérisé en ce que** la distance d entre le bord (4) de la zone d'encapsulation (5) et le bord externe du plot de connexion distal (3) est comprise entre 0 et 500 micromètres.

3. Module électronique (1) selon l'une quelconque des revendications précédentes, **caractérisé en ce que** la distance d'écartement E1 entre les bords internes (8", 10") des puits de connexion (8,10) des deux contacts les plus proches du plot de connexion distal a une valeur d'environ 6 millimètres.

4. Module électronique (1) selon l'une quelconque des revendications précédentes, **caractérisé en ce que** la distance d'écartement E2 entre les bords externes (8', 10') des puits de connexion (8,10) les plus proches du plot de connexion distal a une valeur d'environ 7 millimètres.

5. Module électronique (1) selon l'une quelconque des revendications précédentes, **caractérisé en ce que** les puits de connexion (8,10) des contacts (C1, C5) situés au voisinage du décrochement (20) de l'antenne (2) sont de forme oblongue pour faciliter le passage des fils de connexion entre la puce (12) et lesdits contacts (C1 ou C5).

6. Module électronique (1) selon la revendication 5, **caractérisé en ce que** la largeur des puits de connexion (8,10) situés au voisinage du décrochement (20) de l'antenne (2) est inférieure à 600 micromètres.

7. Module électronique (1) selon l'une quelconque des revendications précédentes, **caractérisé en ce que** la spire (2") la plus interne de l'antenne (2) entoure la zone de la puce microélectronique (12) et comporte plusieurs plots proximaux (A,B,C,D,E,F) répartis le long de la spire interne (2") et correspondant à des longueurs d'antenne différentes et à des inductances différentes, de sorte que l'antenne (2) située entre le plot distal (3) et l'un des plots proximaux (A,B,C,D,E,F) possède une inductance L apte à être sélectionnée, lors de sa connexion à la puce microélectronique et en fonction de la capacité C de celle-ci, pour obtenir une fréquence de résonnance cible.

8. Module électronique (1) selon la revendication 7, **caractérisé en ce que** la spire interne (2") de l'antenne (2) du module comporte au moins six plots de connexion proximaux.

9. Module électronique (1) selon l'une quelconque des revendications précédentes, **caractérisé en ce que** l'inductance L est comprise entre 1,3 et 1,45 micro Henry et que la capacité C de la puce est comprise entre 45 et 104 pico Farad.

10. Carte à puce à double interface de communication à contact et sans contact, **caractérisé en ce qu'**elle comporte un module électronique (1) selon l'une quelconque des revendications 1 à 9.

## Patentansprüche

1. Elektronisches Modul (1) für eine Chipkarte, umfassend ein Substrat (S), das auf einer ersten Seite eine Anschlussleiste mit elektrischen Kontakten (C1, C2, C3, C5, C6, C7) aufweist, die gemäß der Norm ISO 7816 normiert sind und mit den entsprechenden Kontakten eines Chipkartenlesers einen kontaktbehafteten Betrieb gestatten, und das auf einer zweiten Seite eine Antenne (2) und einen mikroelektronischen Chip (12), der durch einen Verkapselungsbereich (5) geschützt ist, umfasst, und wobei der Chip über eine kontaktbehaftete Kommunikationsschnittstelle und eine kontaktlose Kommunikationsschnittstelle verfügt, wobei die elektrischen Kontakte (C1-C7) durch Leiterdrähte (13, 17, 19), die durch Verbindungsschächte (8, 7, 6) verlaufen, mit dem Chip (12) verbunden sind, wobei die Antenne (2) eine Vielzahl von Wicklungen, die sich am Umfang des Moduls befinden, und einen proximalen Verbindungs-Pad und einen distalen Verbindungs-Pad (3), die innerhalb des Verkapselungsbereichs (5) angeordnet sind und dazu bestimmt sind, mit entsprechenden Anschlüssen der kontaktlosen Kommunikationsschnittstelle des Chips (12) verbunden zu sein, umfasst, und wobei die Wicklungen der Antenne (2) eine lokale Abweichung (20) umfassen, die um den distalen Verbindungs-Pad (3) herumführt und in Richtung des Chips (12) gerichtet ist, wobei sich der distale Verbindungs-Pad (3) in einem geringen Abstand d zu dem Rand (4) des Verkapselungsbereichs (5) befindet, **dadurch gekennzeichnet, dass** die Innenränder (8", 10") der Verbindungsschächte (8, 10) der zwei Kontakte, die dem distalen Verbindungs-Pad (3) am nächsten sind, in Bezug auf die Innenränder der Verbindungsschächte der anderen Kontakte zur Außenseite des Moduls hin verschoben sind, um den zwischen dem distalen Verbindungs-Pad (3) und den Verbindungsschächten (8, 10) verfügbaren Raum für den Durchgang der Leiterbahnen der Antenne zu maximieren.

2. Elektronisches Modul (1) nach Anspruch 1, **dadurch gekennzeichnet, dass** der Abstand d zwischen dem Rand (4) des Verkapselungsbereichs (5) und dem Außenrand des distalen Verbindungs-Pads (3) zwischen 0 und 500 Mikrometern liegt.

3. Elektronisches Modul (1) nach einem der vorhergehenden Ansprüche, **dadurch gekennzeichnet, dass** der Trennungsabstand E1 zwischen den Innenrändern (8", 10") der Verbindungsschächte (8, 10) der zwei Kontakte, die dem distalen Verbindungs-Pad am nächsten sind, einen Wert von ungefähr 6 Millimetern aufweist.

4. Elektronisches Modul (1) nach einem der vorhergehenden Ansprüche, **dadurch gekennzeichnet, dass** der Trennungsabstand E2 zwischen den Außenrändern (8', 10') der Verbindungsschächte (8, 10), die dem distalen Verbindungs-Pad am nächsten sind, einen Wert von ungefähr 7 Millimetern aufweist.

5. Elektronisches Modul (1) nach einem der vorhergehenden Ansprüche, **dadurch gekennzeichnet, dass** die Verbindungsschächte (8, 10) der Kontakte (C1, C5), die sich in der Nähe der Abweichung (20) der Antenne (2) befinden, eine längliche Form aufweisen, um den Durchgang der Verbindungsdrähte zwischen dem Chip (12) und den Kontakten (C1 oder C5) zu erleichtern.

6. Elektronisches Modul (1) nach Anspruch 5, **dadurch gekennzeichnet, dass** die Breite der Verbindungsschächte (8, 10), die sich in der Nähe der Abweichung (20) der Antenne (2) befinden, weniger als 600 Mikrometer beträgt.

7. Elektronisches Modul (1) nach einem der vorhergehenden Ansprüche, **dadurch gekennzeichnet, dass** die am weitesten innen liegende Wicklung (2") der Antenne (2) den Bereich des mikroelektronischen Chips (12) umgibt und mehrere proximale Pads (A, B, C, D, E, F) umfasst, die entlang der innen liegenden Wicklung (2") verteilt sind und unterschiedlichen Antennenlängen und unterschiedlichen Induktanzen entsprechen, sodass die Antenne (2), die sich zwischen dem distalen Pad (3) und einem der proximalen Pads (A, B, C, D, E, F) befindet, eine Induktanz L besitzt, die bei ihrer Verbindung mit dem mikroelektronischen Chip und in Abhängigkeit von dessen Kapazität C ausgewählt werden kann, um eine Zielresonanzfrequenz zu erhalten.

8. Elektronisches Modul (1) nach Anspruch 7, **dadurch gekennzeichnet, dass** die innen liegende Wicklung (2") der Antenne (2) des Moduls mindestens sechs proximale Verbindungs-Pads umfasst.

9. Elektronisches Modul (1) nach einem der vorhergehenden Ansprüche, **dadurch gekennzeichnet, dass** die Induktanz L zwischen 1,3 und 1,45 Mikrohenry liegt und dass die Kapazität C des Chips zwischen 45 und 104 Picofarad liegt.

10. Chipkarte mit kontaktbehafteter und kontaktloser doppelter Kommunikationsschnittstelle, **dadurch gekennzeichnet, dass** sie ein elektronisches Modul (1) nach einem der Ansprüche 1 bis 9 umfasst.

## Claims

1. Electronic module (1) for a chip card, the module comprising a substrate (S) having, on a first face, a set of standardized electrical contacts (C1, C2, C3, C5, C6, C7) according to standard ISO 7816, allowing operation by contact with the corresponding contacts of a chip-card reader, and comprising, on a second face, an antenna (2) and a microelectronic chip (12) which is protected by an encapsulation zone (5) and the chip being provided with a contact communication interface and with a contactless communication interface, the electrical contacts (C1-C7) being connected to the chip (12) by conductive wires (13, 17, 19) passing through connection wells (8, 7, 6), the antenna (2) comprising a plurality of turns which are located on the periphery of the module and a proximal connection pad and a distal connection pad (3) which are arranged inside the encapsulation zone (5) and intended to be connected to corresponding terminals of said contactless communication interface of the chip (12), and the turns of the antenna (2) comprising a localized bulge (20) skirting the distal connection pad (3) and oriented in the direction of the chip (12), the distal connection pad (3) being located at a small distance d from the edge (4) of the encapsulation zone (5), **characterized in that** the inner edges (8", 10") of the connection wells (8, 10) of the two contacts closest to the distal connection pad (3) are further towards the outside of the module than the inner edges of the connection wells of the other contacts, so as to maximize the space available between the distal connection pad (3) and said connection wells (8, 10) for the passage of the tracks of the antenna.

2. Electronic module (1) according to Claim 1, **characterized in that** the distance d between the edge (4) of the encapsulation zone (5) and the outer edge of the distal connection pad (3) is between 0 and 500 micrometres.

3. Electronic module (1) according to either one of the preceding claims, **characterized in that** the distance E1 separating the inner edges (8", 10") of the connection wells (8, 10) of the two contacts closest to the distal connection pad has a value of approximately 6 millimetres.

4. Electronic module (1) according to any one of the preceding claims, **characterized in that** the distance E2 separating the outer edges (8', 10') of the connection wells (8, 10) closest to the distal connection pad has a value of approximately 7 millimetres.

5. Electronic module (1) according to any one of the preceding claims, **characterized in that** the connection wells (8, 10) of the contacts (C1, C5) located in the vicinity of the bulge (20) of the antenna (2) are oblong in shape to facilitate the passage of the connection wires between the chip (12) and said contacts (C1 or C5).

6. Electronic module (1) according to Claim 5, **characterized in that** the width of the connection wells (8, 10) located in the vicinity of the bulge (20) of the antenna (2) is less than 600 micrometres.

7. Electronic module (1) according to any one of the preceding claims, **characterized in that** the innermost turn (2") of the antenna (2) surrounds the zone of the microelectronic chip (12) and comprises a plurality of proximal pads (A, B, C, D, E, F) distributed along the inner turn (2") and corresponding to different antenna lengths and different inductances, such that the antenna (2) located between the distal pad (3) and one of the proximal pads (A, B, C, D, E, F) has an inductance L which is able to be selected, when it is connected to the microelectronic chip and depending on the capacitance C of said chip, to obtain a target resonant frequency.

8. Electronic module (1) according to Claim 7, **characterized in that** the inner turn (2") of the antenna (2) of the module comprises at least six proximal connection pads.

9. Electronic module (1) according to any one of the preceding claims, **characterized in that** the inductance L is between 1.3 and 1.45 microhenries and the capacitance C of the chip is between 45 and 104 picofarads.

10. Chip card with a contact and contactless double communication interface, **characterized in that** it comprises an electronic module (1) according to any one of Claims 1 to 9.
